# EUROPÄISCHE PATENTANMELDUNG

(11) **EP 2 557 595 A1**
(43) Veröffentlichungstag der Anmeldung: **13.02.2013**
(21) Anmeldenummer: 12179134.7
(22) Anmeldetag: 03.08.2012
(51) Int. Cl.: H01L 25/16, H01L 25/18

(54) **Leistungselektronisches System mit einer Schalt- und einer Ansteuereinrichtung**

(30) Priorität: 12.08.2011 DE 102011080861
(71) Anmelder: SEMIKRON Elektronik GmbH & Co. KG, 90431 Nürnberg (DE)
(72) Erfinder: Schuler, Stefan, 91052 Erlangen (DE)

(57) **Zusammenfassung**

Die Anmeldung betrifft ein leistungselektronisches System mit einer Schalt- und einer zugeordneten Ansteuereinrichtung, wobei die Schalteinrichtung mehrere Leistungsschalter und mindestens ein Substrat mit einer Mehrzahl voneinander elektrisch isolierter Leiterbahnen aufweist, wobei mindestens ein Leistungsschalter, ausgebildet als mindestens ein Leistungstransistor (110) und mindestens eine Leistungsdiode (120) mit ersten Kontaktflächen, mit einer ersten ein erstes Lastpotential führenden Leiterbahn (302) elektrisch leitend verbunden ist. Zweite, auf der dem Substrat abgewandten Seiten angeordnete, Kontaktflächen sind mittels einer ersten Verbindungseinrichtung (40) als Teil einer internen Verbindungseinrichtung miteinander und mit mindestens einer zweiten ein zweites Lastpotential führenden Leiterbahn (304) verbunden, wobei ein Steueranschluss (116) des mindestens einen Leistungstransistors mit einer Steuerpotential führenden Leiterbahn (306) verbunden ist. Weiterhin ist die zweite Kontaktfläche des Leistungstransistors mit einer weiteren Leiterbahn (308) verbunden, die zwar das zugehörige Lastpotential aufweist, allerdings keinen Laststrom führt. Hierbei ist das Bezugspotential der Ansteuereinrichtung (50, 52) dasjenige der weiteren Leiterbahn des Substrats der Schaltungseinrichtung. Die Ansteuereinrichtung ist direkt mit dieser weiteren Leiterbahn verbunden wobei mindestens ein von der Ansteuereinrichtung erzeugtes Ansteuersignal an der Steuerpotential führenden Leiterbahn anliegt.

## Beschreibung

Die Erfindung beschreibt ein leistungselektronisches System, wie es beispielhaft als Leistungshalbleitermodul mit integrierter oder externer Ansteuereinrichtung bekannt ist.

Aus der DE 298 23 619 sind Leistungshalbleiterschaltungsanordnungen mit einer Mehrzahl von parallel geschalteten Leistungstransistoren bekannt, wobei die Leistungstransistoren auf einem isolierenden Substrat mit einer Mehrzahl von dort ausgebildeten Leiterbahnen angeordnet sind. Beim Betrieb derartiger Leistungshalbleiterschaltungsanordnungen ergeben sich bei verschiedenen Schaltzuständen hochfrequente Schwingungen insbesondere auch im Laststromkreis. Zur Reduktion derartiger Schwingungen ist es bekannt die Emitter, vorzugsweise benachbarter, Leistungstransistoren direkt zu verbinden. Ebenso ist es bekannt die Geometrie der Leiterbahnen zu modifizieren.

Aus obiger Druckschrift, sowie allgemein bekannt ist es Verbindungseinrichtungen zur Verbindung der Leistungstransistoren mit zugeordneten Leiterbahnen als Drahtbondverbindungen auszubilden. Hierbei sollen unter diesem Begriff verschiedene grundlegend technisch gleichartige Ausgestaltungen, beispielhaft Bandbondverbindungen, subsummiert werden. Ebenso allgemein bekannt ist es derartige Verbindungseinrichtungen zusätzlich oder alternativ den Drahtbondverbindungen als flexible Leiterplatten, beispielhaft aus einer Schichtfolge leitender und isolierender Folien, die in sich strukturiert sein können, auszubilden.

Es hat sich neben der oben beschriebenen Schwingungsneigung mehrerer Leistungstransistoren gezeigt, dass auch die Kombination aus nur einem Leistungstransistor und einer dazu antiparallel geschalteten Leistungsdiode ebenfalls unter bestimmten Betriebsbedingungen zur Schwingung in einem hochfrequenten Bereich neigt.

Der Erfindung liegt somit die Aufgabe zugrunde ein leistungselektronisches System vorzustellen, das mindestens eine Schalteinrichtung mit mindestens einer zugeordneten Ansteuereinrichtung derart ausgestaltet und kombiniert, dass die Schwingungsneigung auch nur eines Leistungstransistors und einer antiparallel dazu geschalteten Leistungsdiode wirkungsvoll unterdrückt wird.

Die Aufgabe wird erfindungsgemäß gelöst durch ein leistungselektronisches System mit den Merkmalen des Anspruchs 1. Bevorzugte Ausführungsformen sind in den abhängigen Ansprüchen beschrieben.

Im Folgenden wird jeweils von einem Leistungsschalter ausgegangen der als mindestens ein Leistungstransistor mit mindestens einer antiparallel geschalteten Leistungsdiode ausgebildet ist. Die Verallgemeinerung auf verschiedene Schaltungstopologien, wie Halbbrücken mit einem ersten und einem zweiten Leistungsschalter oder auch auf Multilevelschaltungstopologien, wie sie als solche ebenfalls bekannt sind, erfolgt selbstverständlich analog.

Das erfindungsgemäße leistungselektronische System besteht mindestens aus einer Schalt- und aus mindestens einer zugeordneten Ansteuereinrichtung. Hierbei ist die mindestens eine jeweilige Schalteinrichtung ausgebildet als eine leistungselektronische Schaltung, die mindestens ein Substrat mit einer Mehrzahl voneinander elektrisch isolierter Leiterbahnen aufweist. Auf einer ersten ein erstes Lastpotential führenden Leiterbahn ist ein Leistungsschalter angeordnet. Dieser Leistungsschalter ist ausgebildet als mindestens ein Leistungstransistor und mindestens eine Leistungsdiode. Beide weisen auf ihrer ersten Oberfläche mindestens eine erste Kontaktfläche zur Lastverbindung auf. Diese jeweiligen ersten Kontaktflächen sind mit der ersten Leiterbahn elektrisch leitend verbunden. Auf der dem Substrat abgewandten Seite weisen beide zweite Kontaktflächen zur Lastverbindung auf. Der Leistungstransistor weist auf dieser Seite zusätzlich eine Kontaktfläche zur Steuerverbindung auf.

Vorzugsweise ist der Leistungstransistor als IGBT (insulated gate bipolar transistor) ausgestaltet, dessen erste Kontaktfläche den Kollektoranschluss ausbildet, während die zweite Kontaktfläche den Emitteranschluss ausbildet. Vorzugsweise bildet die erste Kontaktfläche der Leistungsdiode deren Kathode aus, während die zweite Kontaktfläche deren Anode ausbildet.

Vorzugsweise sind jeweils die zweite Kontaktfläche, der Emitteranschluss, eines Leistungstransistors mit einer zweiten Kontaktfläche, dem Anodenanschluss, einer Leistungsdiode mittels einer ersten Verbindungseinrichtung als Teil der internen Verbindungseinrichtung miteinander und mit mindestens einer zweiten ein zweites Lastpotential führenden Leiterbahn verbunden. Diese zweite Leiterbahn kann beispielhaft mit einem externen Lastanschlusselement verbunden sein und gleichzeitig oder alternativ auch weitere Leistungsschalter in grundsätzlich gleicher wie oben genannter Weise tragen.

Erfindungsgemäß ist die zweite Kontaktfläche mindestens eines Leistungstransistors mit einer weiteren Leiterbahn verbunden, die zwar das zugehörige Lastpotential aufweist, allerdings keine Lastströme führt. Diese weitere Leiterbahn bildet für die zugeordnete Ansteuereinrichtung das Bezugspotential. Hierzu ist die Ansteuereinrichtung mit der weiteren Leiterbahn des Substrats der Schaltungseinrichtung direkt und ausschließlich verbunden. Eine direkte Verbindung, neben der indirekten Verbindung über die Leistungsdiode, der Ansteuereinrichtung zu einer zweiten Leiterbahn des Substrats besteht somit nicht.

Bei einer Mehrzahl von Leistungstransistoren pro Leistungsschalter kann genau ein Leistungstransistor mit seiner zweiten Kontaktfläche mit der weiteren Leiterbahn des Substrats verbunden sein, oder eine Mehrzahl von Leistungstransistoren können mit ihren zweiten Kontaktflächen mit der weiteren Leiterbahn des Substrats verbunden sein, oder alle Leistungstransistoren können mit ihren zweiten Kontaktflächen mit der weiteren Leiterbahn des Substrats verbunden sein.

Es ist weiterhin bekannt, dass ein Leistungstransistor eine Mehrzahl von zweiten Kontaktflächen aufweist. Hierbei kann es vorteilhaft sein nur eine oder eine Mehrzahl oder alle zweiten Kontaktflächen entsprechend zu verbinden.

Weiterhin ist der Steueranschluss des mindestens einen Leistungstransistors, dessen Kontaktfläche ebenfalls auf der dem Substrat abgewandten Seite angeordnet ist, mit einer Steuerpotential führenden Leiterbahn und hierüber mit der zugeordneten Ansteuerschaltung verbunden. Hierdurch ist ein von der Ansteuereinrichtung erzeugtes Ansteuersignal mit der Steuerpotential führenden Leiterbahn und hierüber mit dem Steueranschluss der Leistungstransistoren verbunden.

Alle genannten Verbindungen, die nicht mittels des Substrats selbst ausgebildet sind, sind mittels der internen Verbindungseinrichtung ausgebildet, die entweder als Mehrzahl von Drahtbondverbindungen und zusätzlich oder alternativ mittels mindestens einer flexiblen Leiterplatte ausgebildet ist.

Die erfinderische Lösung wird an Hand der Ausführungsbeispiele gemäß den Fig. 1 bis 3 weiter erläutert.

Fig. 1 zeigt in einer leistungselektronischen Grundschaltung den Stand der Technik, wie auch schematisch die grundsätzliche erfinderische Idee.

Fig. 2 zeigt einen Querschnitt durch einen Teil einer ersten Ausgestaltung eines erfindungsgemäßen leistungselektronischen Systems.

Fig. 3 zeigt eine Draufsicht auf einen Teil einer zweiten Ausgestaltung eines erfindungsgemäßen leistungselektronischen Systems.

Das erfindungsgemäße leistungselektronische System wird im Folgenden anhand einer Halbbrückenschaltung beschrieben. Grundsätzlich sind gemäß der Erfindung auch andere Schaltungstopologien, wie beispielhaft Gleichspannungsbrückenschaltungen oder Multilevelbrückenschaltungen mit mehr als zwei in Reihe geschalteten Leistungsschaltern je Brückenschaltung ausbildbar.

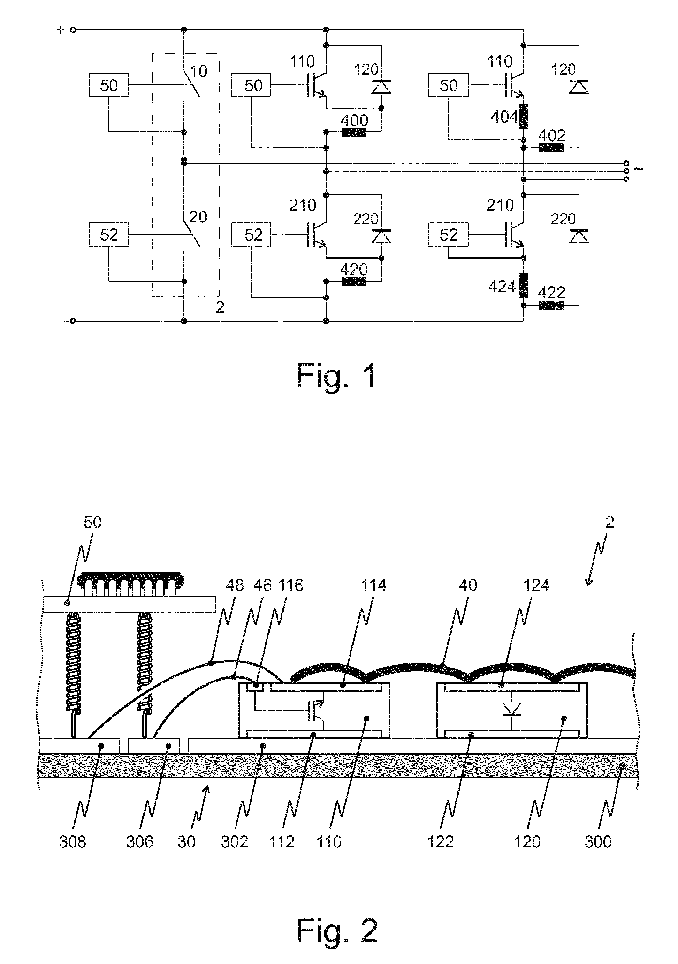

Fig. 1 zeigt in einer leistungselektronischen Grundschaltung den Stand der Technik, wie auch schematisch die grundsätzliche erfinderische Idee. Dargestellt sind hierzu drei Halbbrückenschaltungen.

Die erste, linke Halbbrückenschaltung zeigt eine allgemeine Darstellung, mit einem ersten, oberen, auch "TOP" genannten, Leistungsschalter 10 und einem zweiten, unteren, auch "BOT", genannten Leistungsschalter 20. Diese Leistungsschalter 10, 20 sind mit einer Gleichspannungsquelle verbunden, während ihre Mittelanzapfung den Wechselspannungsausgang der ersten Phase bildet.

Die mittig dargestellte Halbbrückenschaltung zeigt schematisch die Umsetzung gemäß dem Stand der Technik, während die rechte die erfindungsgemäße Umsetzung darstellt. Bei beiden Halbbrückenschaltungen sind die jeweiligen Leistungsschalter 10, 20 als ein Leistungstransistor 110, 210, konkret als ein IGBT (insulated gate bipolar transistor) mit einer antiparallel geschalteten Leistungsdiode 120, 220 ausgebildet. Grundsätzlich kann natürlich jeder Leistungsschalter 10, 20 auch mehr als einen Leistungstransistor 110, 210 und auch mehr als eine Leistungsdiode 120, 220 aufweisen.

Gemäß dem Stand der Technik, schematisch dargestellt in der mittleren Halbbrückenschaltung, sind die ersten Kontaktflächen, die Kollektor-Kontaktfläche 112, vgl. Fig. 2, des TOP-Leistungstransistors 110 und die erste Kontaktfläche, die Kathoden-Kontaktfläche 122, vgl. Fig. 2, der TOP-Leistungsdiode 120 auf einer ersten Leiterbahn 302, vgl. Fig. 2 des Substrats 30, vgl. Fig. 2 angeordnet. Mittels der internen Verbindungseinrichtung, meist ausgebildet als Drahtbondverbindungen, sind die zweiten Kontaktflächen, die Emitter-Kontaktfläche 114, vgl. Fig. 2 des TOP-Leistungstransistors 110 und die Anoden-Kontaktfläche 124, vgl. Fig. 2 der TOP-Leistungsdiode 120 miteinander und mit einer zweiten Leiterbahn verbunden. Diese zweite Leiterbahn trägt hier die Komponenten des BOT-Leistungsschalters 20 und bildet für diese wiederum eine erste Leiterbahn gemäß der Erfindung aus.

Die erste interne, Lastpotential und Laststrom führende, Verbindungseinrichtung 40, vgl. Fig. 2, zwischen der Emitter-Kontaktfläche des Leistungstransistor und der zweiten Leiterbahn weist hierbei eine parasitäre Induktivität 400, 420 im Bereich zwischen 5nH und 40nH, häufig zwischen 10nah und 20nH, auf. Diese bildet mit den internen Kapazitäten, insbesondere derjenigen der sog. Gate-Emitter-Kapazität, des Leistungstransistors 110, 210 einen Schwingkreis aus, der im Betrieb, bei der Kommutierung, infolge der dabei auftretenden schnelle Änderungen des Stromes, hochfrequente Schwingungen erzeugt, die auf die Ansteuereinrichtung 50, 52, deren Bezugspotential auf dem Potential der zweiten Leiterbahn liegt, rückwirken.

Bei der erfindungsgemäßen Ausgestaltung liegt das Bezugspotential der Ansteuereinrichtung auf einer weiteren Leiterbahn 308, vgl. Fig. 2, die das gleiche Lastpotential aufweist wie die zweite Leiterbahn, allerdings keinen Laststrom führt. Durch geeignete Wahl desjenigen Teils der ersten internen Verbindungseinrichtung zwischen der Emitter-Kontaktfläche und dieser weiteren Leiterbahn, kann die parasitäre Induktivität desjenigen Teils der internen Verbindungseinrichtung der die Lastströme führt teilweise, vgl. TOP-Leistungsschalter der rechten Halbbrücke oder sogar vollständig, vgl. BOT-Leistungsschalter der rechten Halbbrücke, wirkungslose für die Rückwirkung auf die Ansteuereinrichtung sein. Bei der teilweisen Rückwirkung auf den Schwingkreises wird die parasitäre Induktivität der ersten internen Verbindungseinrichtung quasi in eine erste 402, 422 wirksame und eine zweite 404, 424 unwirksame Teilinduktivität aufgeteilt.

Fig. 2 zeigt einen Querschnitt durch einen Teil einer ersten Ausgestaltung eines erfindungsgemäßen leistungselektronischen Systems. Dargestellt ist hier eine Schalteinrichtung 2, beispielhaft ausgestaltet als ein Leistungshalbleitermodul, sowie eine zugeordnete Ansteuereinrichtung 50, hier ausgebildet als eine Treiberschaltung direkt oberhalb des Leistungshalbleitermoduls 2 angeordnet.

Das Leistungshalbleitermodul 2 weist ein Substrat 30 mit einer Mehrzahl elektrisch voneinander isolierter Leiterbahnen 302, 306, 308 auf. Hierzu weist das Substrat 30 einen Isolierstoffkörper 300, vorzugsweise aus einer Industriekeramik ausgebildet, auf, auf dem die Leiterbahnen vorzugsweise flächig, angeordnet sind. Auf ersten Leiterbahnen 302 ist der jeweilige Leistungsschalter, hier ausgebildet als ein IGBT 110 und eine Leistungsdiode 120 angeordnet. Hierbei sind die Kollektor-Kontaktfläche 112 des IGBTs 110 und die Kathoden-Kontaktfläche 122 der Leistungsdiode 120 stoffschlüssig und elektrisch leitend mit der ersten Leiterbahn 302 verbunden.

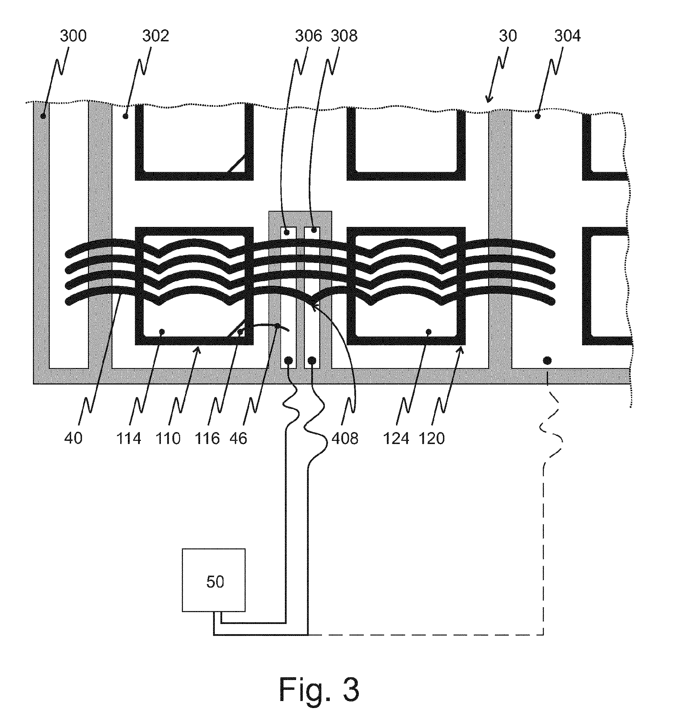

Die interne Verbindungseinrichtung ist hier ausgebildet mittels Drahtbondverbindungen. Hierbei verbinden eine Mehrzahl, dargestellt ist nur eine, von Laststrom führenden erste Drahtbondverbindungen 40 die Emitter-Kontaktfläche 114 des IGBT 110 mit der Anoden-Kontaktfläche 124 der Leistungsdiode 120 und mit einer ebenfalls nicht dargestellten zweiten Lastpotential und Laststrom führenden Leiterbahn 304, vgl. Fig. 3.

Der Steueranschluss, die Gate-Kontaktfläche 116, des IGBT 110 ist mit einer zugeordneten Steuerpotential führenden Leiterbahn 306 ebenfalls mittels einer zweiten Drahtbondverbindung 46, typischerweise mit geringerem Durchmesser des Bonddrahtes verbunden.

Eine weitere, Drahtbondverbindung 48 verbindet die Emitter-Kontaktfläche 114 mit einer weiteren Leiterbahn 308 des Substrats 30, wobei diese weitere Drahtbondverbindung 48 wie auch die zugeordnete weitere Leiterbahn 308 Lastpotential, aber keinen Laststrom führen.

Die Ansteuerschaltung 50 ist erfindungsgemäß ausschließlich mit der Steuerpotential führenden Leiterbahn 306 und der weiteren Leiterbahn 308 verbunden. Dargestellt ist hier eine in Leistungshalbleitermodulen übliche Verbindung mittels Kontaktfedern zu der meist außerhalb des Leistungshalbleitermoduls 2 angeordneten Ansteuereinrichtung 50.

Bei dieser besonders vorteilhaften Ausgestaltung des leistungselektronischen Systems wirken die parasitären Induktivitäten der Laststrom führenden Drahtbondverbindungen und die hierdurch erzeugten unerwünschten hochfrequenten Schwingungen nicht auf die Ansteuereinrichtung 50 zurück. Diese Ausgestaltung entspricht gemäß Fig. 1 dem BOT-Leistungsschalter 20 der rechten Halbbrücke.

Fig. 3 zeigt eine Draufsicht auf einen Teil einer zweiten Ausgestaltung eines erfindungsgemäßen leistungselektronischen Systems. Dargestellt ist wiederum ein Substrat 30, das grundsätzlich gleichartig demjenigen unter Fig. 2 beschriebenen ausgebildet ist und auf dem ebenso analog ein IGBT 110 und eine Leistungsdiode 120 angeordnet sind. Die Verbindung der Ansteuereinheit 50 unterscheidet sich im Grunde ebenso wenig von derjenigen gemäß Fig. 2.

Unterschiedlich ist hierbei allerdings, dass die Drahtbondverbindung 40 zwischen der Emitter-Kontaktfläche 114 des IGBT 110 und der weiteren Leiterbahn 308 Lastpotential und Laststrom führt. Die weitere Leiterbahn 308 selbst führt allerdings erfindungsgemäß keinen Laststrom.

Gestrichelt dargestellt ist der Stand der Technik bei dem das Bezugspotential der Ansteuereinrichtung 50 mit einer Lastpotential und Laststrom führenden zweiten Leiterbahn 304 verbunden ist und wobei diese über die laststromführende Abschnitte der internen Verbindungseinrichtung, hier die entsprechenden ersten Drahtbondverbindungen 40, mit der Emitter-Kontaktfläche 114 des IGBTs 110 verbunden ist.

Dies ist dahingehend vorteilhaft, dass keine zusätzliche, weitere, Drahtbondverbindung 48, vgl. Fig. 2 vorgesehen werden muss, sondern eine bestehende durch Setzen eines zusätzlichen Bondfußes 408 auf der weiteren Leiterbahn 308 ergänzt wird.

Bei dieser Ausgestaltung des leistungselektronischen Systems wirken die parasitären Induktivitäten der Laststrom führenden Drahtbondverbindungen und die hierdurch erzeugten unerwünschten hochfrequenten Schwingungen nur teilweise auf die Ansteuereinrichtung 50 zurück. Diese Ausgestaltung entspricht gemäß Fig. 1 dem TOP-Leistungsschalter 10 der rechten Halbbrücke.

## Patentansprüche

1. Leistungselektronisches System mit mindestens einer Schalt- (2) und mindestens einer zugeordneten Ansteuereinrichtung (50, 52), wobei
die jeweilige Schalteinrichtung (2) mehrere Leistungsschalter und mindestens ein Substrat (30) mit einer Mehrzahl voneinander elektrisch isolierter Leiterbahnen (302, 304, 306, 308) aufweist, wobei mindestens ein Leistungsschalter (10, 20), ausgebildet als mindestens ein Leistungstransistor (110, 210) und mindestens eine Leistungsdiode (120, 220) mit jeweiligen ersten Kontaktflächen (112, 122), mit einer ersten ein erstes Lastpotential führenden Leiterbahn (302) elektrisch leitend verbunden ist, jeweilige zweite, auf der dem Substrat abgewandten Seiten des mindestens einen Leistungstransistors (110, 210) und der mindestens einen Leistungsdiode (120, 220) angeordnete Kontaktflächen (114, 124) mittels einer ersten Verbindungseinrichtung (40) als Teil einer internen Verbindungseinrichtung (40, 46, 48) miteinander und mit mindestens einer zweiten ein zweites Lastpotential führenden Leiterbahn (304) verbunden sind, wobei ein Steueranschluss (116) des mindestens einen Leistungstransistors (110) mit einer Steuerpotential führenden Leiterbahn (306) verbunden ist, und die zweite Kontaktfläche (114) mindestens eines Leistungstransistors (110, 210) mit einer weiteren Leiterbahn (308) verbunden ist, die zwar das zugehörige Lastpotential aufweist, allerdings keinen Laststrom führt, und wobei das Bezugspotential der zugeordneten Ansteuereinrichtung (50, 52) dasjenige der weiteren Leiterbahn (308) des Substrats (30) der Schaltungseinrichtung (2) ist und die Ansteuereinrichtung (50, 52) bezüglich ihres Bezugspotentials direkt und ausschließlich mit dieser weiteren Leiterbahn (308) aber keiner weiteren Lastpotential führenden Leiterbahn (304) verbunden ist und mindestens ein von der Ansteuereinrichtung (50, 52) erzeugtes Ansteuersignal an der Steuerpotential führenden Leiterbahn (306) anliegt.

2. Leistungselektronisches System nach Anspruch 1, wobei der Leistungstransistor (110, 210) ein IGBT (insulated gate bipolar transistor) ist und mit seinem ersten Kontaktfläche, der Kollektor-Kontaktfläche (112), mit der ersten Leiterbahn (302) des Substrats (30) verbunden ist.

3. Leistungselektronisches System nach Anspruch 1, wobei die Leistungsdiode (120, 220) mit ihrer ersten Kontaktfläche, der Kathoden-Kontaktfläche (122) mit der ersten Leiterbahn (302) des Substrats (30) verbunden ist.

4. Leistungselektronisches System nach Anspruch 1, wobei bei einer Mehrzahl von Leistungstransistoren (110, 210) pro Leistungsschalter (10, 20) genau ein Leistungstransistor (110, 210) mit seiner zweiten Kontaktfläche, der Emitter-Kontaktfläche (114) mit der weiteren Leiterbahn (308) des Substrats (30) verbunden ist, oder eine Mehrzahl von Leistungstransistoren (110, 210) mit ihren zweiten Kontaktflächen (114) mit der weiteren Leiterbahn (308) des Substrats (30) verbunden sind, oder alle Leistungstransistoren mit ihren zweiten Kontaktflächen (114) mit der weiteren Leiterbahn (308) des Substrats (30) verbunden sind.

5. Leistungselektronisches System nach Anspruch 1, wobei die interne Verbindungseinrichtung aus einer Mehrzahl von Drahtbondverbindungen (40, 46, 48) ausgebildet ist.

6. Leistungselektronisches System nach Anspruch 5, wobei eine aus einer Mehrzahl von Drahtbondverbindungen (40) zwischen den zweiten Kontaktflächen (114, 124) eines Leistungstransistors (110, 210) und einer Leistungsdiode (120, 220) einen Bondfuß (408) auf der weiteren Leiterbahn (308) aufweist.

7. Leistungselektronisches System nach Anspruch 5, wobei eine weitere Drahtbondverbindung (48) zwischen der zweiten Kontaktfläche (114) des jeweiligen Leistungstransistors (110, 210) und der weiteren Leiterbahn (308) vorgesehen ist.

8. Leistungselektronisches System nach Anspruch 7, wobei der Bonddraht der weiteren Drahtbondverbindung (48) einen wesentlich geringeren Durchmesser aufweist als diejenigen Bonddrähte der Drahtbondverbindung (40), die die zweiten Kontaktflächen (114, 124) des Leistungstransistors (110, 210) und der Leistungsdiode (120, 220) verbinden.

9. Leistungselektronisches System nach Anspruch 1, wobei die Verbindungseinrichtung aus einer flexiblen Leiterplatte ausgebildet ist.
